# EUROPEAN PATENT APPLICATION

(11) **EP 2 475 232 A1**
(43) Date of publication of application: **11.07.2012**
(21) Application number: 11181518.9
(22) Date of filing: 15.09.2011
(51) Int. Cl.: H05K 1/03, H05K 1/05, H05K 1/18

(54) **Lighting device and method for forming the same**

(30) Priority: 07.01.2011 TW 100100572; 21.01.2011 TW 100102331
(71) Applicant: Fitilite (s) Pte. Ltd. Taiwan Branch, Jhunan Township, Miaoli County 350 Chinese Taipei (TW)
(72) Inventor: Lin, Puru, 350 Miaoli County (TW)
(74) Representative: Lang, Christian

(57) **Abstract**

The present invention provides a lighting device and method for forming the same. The lighting device comprises a base having a first surface, a conductive wiring layer formed on the first surface, and a light emitting diode module comprising a substrate and at least one light emitting diode disposed on the substrate wherein the substrate of the light emitting diode module is disposed on the conductive wiring layer by a surface mount method. In one embodiment, the base is preferably made of ceramics.

## Description

### (a) Field of the Invention

The invention relates to a lighting device and a method for forming the same, particularly to a lighting device and a method for forming the same with excellent heat dissipation.

### (b) Description of the Related Art

Generally, a lighting device using light emitting diodes (LEDs) as the light source needs good heat dissipation because the lifetime and brightness of a LED decrease with increasing temperature where electric energy is converted into heat. Furthermore, in the illumination application, in order to achieve high brightness, a LED module in the lighting device usually comprises a plurality of high power LED chips. In addition, in order to fulfill optical requirements, the high power LED chips are closely distributed or packed together to simulate as a single light source. Therefore, according to the above design principle, heat dissipation becomes much more important.

Therefore, on the lighting device, especially for illumination, not only the substrate loaded with high power LED chips needs good thermal conductivity but also the base (so called lamp holder) that the LED module comprising the substrate and the high power LED chips is disposed on needs good heat dissipation or high radiation rate. Besides, interfaces between components of the lighting device should have low thermal resistance to lower the junction temperature of the LED chip (p-n junction temperature of the LED chip) to further prolong the lifetime of the LED and increase the brightness of the LED.

Various designs for a LED module for example referring to US patent No. 7,489,076, JP publication No. 2006-261290, or US publication No. 2005/133808 were developed to improve heat dissipation and lighting characteristics. Besides, for example, US patent No. 7,759,144 discloses a LED package using a sandwiched ceramic substrate where a copper layer is separately directly connected to the upper and lower surfaces of the sandwiched ceramic substrate to achieve the heat dissipation effect at the junction between components.

However, when a LED module is disposed on a base (or lamp holder) to comprise a lighting device or illuminating device, the base usually has a three-dimensional shape, that is, the base usually is not flat like a thin film and assembling the LED module and the base together cannot be performed by a simple machine. Thus, this process is usually done manually. That is, fixture members like screws are used to mount the LED module by hands. In order to reduce the thermal resistance between the LED module and the base, a heat sink or heat dissipating paste is applied on the interface between the LED module and the base. However, the thermal conductivity of a heat sink or heat dissipating paste is low (around 3W/m-K) and heat on the LED module still cannot be conducted to the base. Thus, the heat dissipation bottleneck still exists. In conclusion, the lighting device cannot be manufactured by automatic equipments currently and the production cost of the lighting device is high. Besides, the heat dissipation between the LED module and the base is still insufficient.

### BRIEF SUMMARY OF THE INVENTION

In light of the above-mentioned problem, in order to fulfill the industrial requirements, one object of the invention is to provide a lighting device and a method for forming the same with excellent heat dissipation effect. According to the design of the invention, the thermal resistance of the interface between the LED module and the base is improved, the radiation rate of the base is high, and the heat dissipation effect of the overall lighting device is improved to thereby reduce the junction temperature of the LED during operation so as to prolong the lifetime of the LED and increase the brightness of the LED.

One object of the invention is to provide a lighting device using a ceramic base to possess high voltage durability. That is, the leakage current of the lighting device is very low (lower than the measurable scale, such as less than 1 nA) even when 4000V or higher is applied on the base. The lighting device using a ceramic base is more satisfactory in international safety regulation than that using a metal base.

Furthermore, another object of the invention is to provide a lighting device where the LED module and the base are connected by an automatic screen printing machine or an automatic dispenser mounted on a three-axis movable stage to thereby simplify the assembling processes to reduce production cost. Besides, the thermal resistance of the interface between the LED module and the base is reduced and the heat dissipation efficiency of the lighting device is thereby improved.

In order to achieve the above purpose(s), one embodiment of the invention provides a method for forming a lighting device. The method comprises: providing a base, having a first surface; forming a conductive wiring layer on the first surface; providing a light emitting diode (LED) module wherein the LED module comprises a substrate and a light emitting diode chip disposed on the substrate; and having the substrate of the LED module disposed on the conductive wiring layer by a surface mount method to thereby form the lighting device.

In one embodiment, the base is formed by the material selected from the group consisting of the following: aluminum having surface oxidization treated, aluminum having an oxide layer on the surface, aluminum oxide, and aluminum nitride. In one embodiment, the step of forming a conductive wiring layer on the first surface comprises printing metal paste on the first surface by a screening printing method or using an automatic dispenser mounted on a three-axis movable stage and performing firing to thereby form the conductive wiring layer. The above metal paste is preferably silver paste.

In another embodiment, the step of forming a conductive wiring layer on the first surface comprises: forming a first metal layer; forming a second metal layer; forming a film with a pattern on the second metal layer; simultaneously etching the first metal layer and the second metal layer to pattern the first metal layer and the second metal layer; and removing residue of the film.

In one embodiment, the surface mount method uses solder paste to bond the substrate and the conductive wiring layer by reflow soldering. The above solder paste is preferably soldering tin.

In one embodiment, the conductive wiring layer comprises a wiring pattern. In one embodiment, the effective thermal conductivity of the solder paste, the interface between the solder paste and the substrate and the interface between the solder paste and the conductive wiring layer is equal to or more than 50 W/m-K. The "effective thermal conductivity (k_{eff}) " is defined as 1/k_{eff} =1/k₁+1/k₂+1/k₃ where k₂ denotes the thermal conductivity of the solder paste, k₁ denotes the thermal conductivity (k₁) of the interface (void) between the solder paste and the substrate, and k₃ denotes the thermal conductivity of the interface (void) between the solder paste and the conductive wiring layer.

In one embodiment, the screen printing method utilizes a specific tool to couple with the base to assist in coating the metal paste on the first surface.

The leakage current of the lighting device is very low (lower than the measurable scale, such as less than 1 nA) even when 4000V or higher is applied on the base.

Another embodiment of the invention provides a lighting device, comprising: a base having a first surface; a conductive wiring layer formed on the first surface; and a light emitting diode module comprising a substrate and at least one light emitting diode chip disposed on the substrate wherein the substrate of the light emitting diode module is disposed on the conductive wiring layer by a surface mount method. In one embodiment, the base is formed by the material selected from the group consisting of the following: aluminum having surface oxidization treated, aluminum having an oxide layer on the surface, aluminum oxide, and aluminum nitride. The base is preferably of ceramics, for example, aluminum oxide.

In one embodiment, the effective thermal conductivity of the solder paste, the interface between the solder paste and the substrate and the interface between the solder paste and the conductive wiring layer is equal to or more than 50 W/m-K. The leakage current of the lighting device is very low (lower than the measurable scale, such as less than 1 nA) even when 4000V or higher is applied on the base. In one embodiment, the conductive wiring layer is formed by silver paste and comprises a wiring pattern. In one embodiment, soldering tin is disposed between the conductive wiring layer and the substrate of the light emitting diode module.

In another embodiment, the conductive wiring layer comprises a multi-layer structure formed by sequentially laminating a seed layer, and a copper layer and the conductive wiring layer comprises a wiring pattern. The method of forming the conductive wiring layer having a multi-layer structure comprises: sputtering a first metal layer as the seed layer wherein the seed layer is formed by titanium (Ti) or titanium tungsten (TiW) materials; electroplating a copper layer as the second metal layer; forming a film with a pattern on the second metal layer; simultaneously etching the first metal layer and the second metal layer to pattern the first metal layer and the second metal layer; and removing residue of the film.

Therefore, according to the design of the lighting device and the method for forming the lighting device of the invention, manufacturing a lighting device can be done by automation and the production cost is decreased. Furthermore, the heat conductivity between the LED module and the base is increased to thereby increase the heat dissipation efficiency of the whole lighting device and lower the junction temperature of the LED during operation. Thus, the lifetime of the LED and brightness can be increased. Besides, when a ceramic base is used, the lighting device has high voltage durability. That is, the leakage current of the lighting device is very low (lower than the measurable scale, such as less than 1 nA) even when 4000V or higher is applied on the base.

Other objects and advantages of the invention can be better understood from the technical characteristics disclosed by the invention. In order to clarify the above mentioned and other objects and advantages of the invention, examples accompanying with figures are provided and described in details in the following.

### Brief description of the drawings

FIG. 1 shows a schematic diagram illustrating a lighting device according to the prior art.

FIG. 2 shows a schematic diagram illustrating a lighting device according to one embodiment of the invention.

FIG. 3 shows a top-view schematic diagram illustrating the structure of the lighting device for simulating heat dissipation effect according to one embodiment of the invention.

FIG. 4 shows a flow chart illustrating a method for forming a lighting device according to one embodiment of the invention.

FIG. 5 shows a flow chart illustrating the method for forming the conductive wiring layer 300 where on the right-hand side of FIG. 5 shows the cross-sectional schematic diagrams of the lighting device according to one embodiment of the invention.

FIG. 6(a) shows a schematic diagram illustrating the pattern of the conductive wiring layer according to one embodiment of the invention.

FIG. 6(b) shows a schematic diagram illustrating a lighting device according to one embodiment of the invention.

### DETAILED DESCRIPTION OF THE INVENTION

In the following detailed description of the preferred embodiments, reference is made to the accompanying drawings which form a part hereof, and in which are shown by way of illustration specific embodiments in which the invention may be practiced. In this regard, directional terminology, such as "top," "bottom," "front," "back," etc., is used with reference to the orientation of the Figure(s) being described. The components of the invention can be positioned in a number of different orientations. As such, the directional terminology is used for purposes of illustration and is in no way limiting. On the other hand, the drawings are only schematic and the sizes of components may be exaggerated for illustration. It is to be understood that other embodiments may be utilized and structural changes may be made without departing from the scope of the invention. Also, it is to be understood that the phraseology and terminology used herein are for the purpose of description and should not be regarded as limiting. The use of "including," "comprising," or "having" and variations thereof herein is meant to encompass the items listed thereafter and equivalents thereof as well as additional items. Unless limited otherwise, the terms "connected," "coupled," and "mounted" and variations thereof herein are used broadly and encompass direct and indirect connections, couplings, and mountings. Similarly, the terms "facing," "faces" and variations thereof herein are used broadly and encompass direct and indirect facing, and "adjacent to" and variations thereof herein are used broadly and encompass directly and indirectly "adjacent to". Therefore, the description of "A" component facing "B" component herein may contain the situations that "A" component directly faces "B" component or one or more additional components are between "A" component and "B" component. Also, the description of "A" component "adjacent to" "B" component herein may contain the situations that "A" component is directly "adjacent to" "B" component or one or more additional components are between "A" component and "B" component. Accordingly, the drawings and descriptions will be regarded as illustrative in nature and not as restrictive.

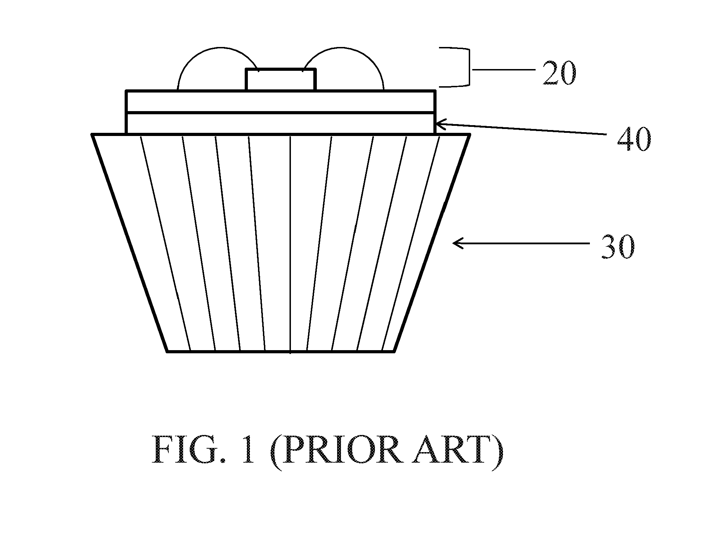

FIG. 1 shows a schematic diagram illustrating a lighting device according to the prior art. The lighting device 10 comprises a LED module 20, a base 30, and a heat dissipating plate 40 between the LED module 20 and the base 30. The LED module 20 comprises a substrate and a plurality of LED chips disposed on the substrate. The substrate can be, for example, an aluminum substrate, a copper substrate, a metal core printed circuit board (MCPCB), an aluminum oxide substrate, an aluminum nitride substrate, or any other ceramic substrates, etc. The LED chip can be for example various types of LED chips or high power LED chips. The base 30 can be for example made of ceramics, aluminum oxide, aluminum nitride, etc. The shape of the base 30 in FIG. 1 is only an example and the base 30 can be formed into various shapes depending on actual needs. Besides, the base 30 can also be formed together with various heat dissipating fins or any shape having a function of heat dissipation. The heat dissipating plate 40 can be for example made of silicon-containing polymer having a thickness of 0.5 mm. However, there are many holes at the interfaces between the LED module 20 and the heat dissipating plate 40 and between the heat dissipating plate 40 and the base 30. Even though heat dissipating paste is used to fill these holes, the heat dissipation efficiency is still insufficient. The temperature of the LED module increases along with increasing operation duration due to poor heat dissipation efficiency. On the other hand, if the base 30 is made of metal, the surface of the base can be coated with enamel paint to form an insulation layer but the thin insulation layer cannot resist the impact of high voltage. That is, the device cannot pass the 4000V high voltage test and the device will fail when 4000V voltage is applied.

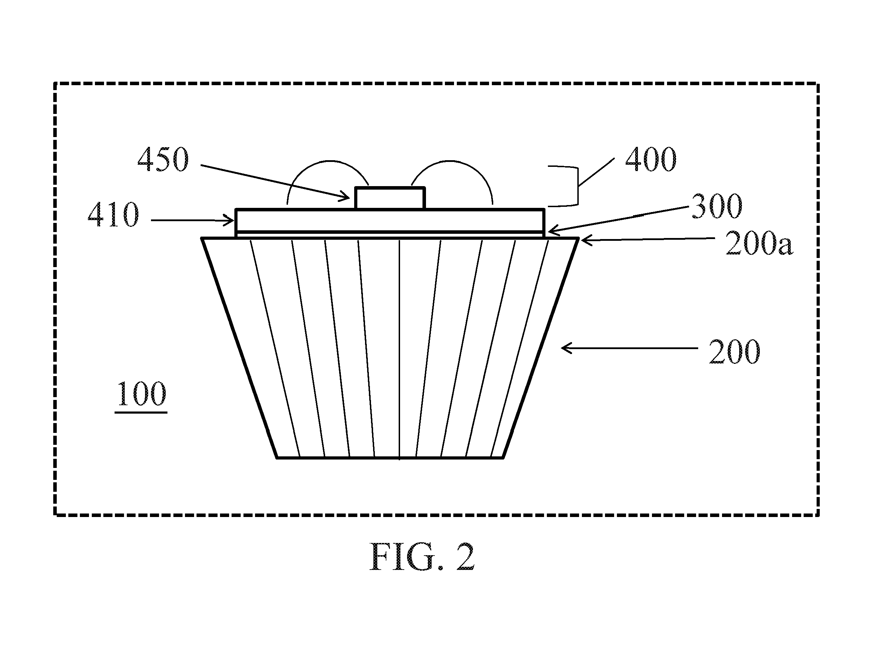

Therefore, in light of the above problems, the invention provides a lighting device having excellent heat dissipating mechanism and being able to pass the safety test, that is, the 4000V high voltage test. FIG. 2 shows a schematic diagram illustrating a lighting device according to one embodiment of the invention. The light device 200 comprises a base 200 having a first surface 200a; a conductive wiring layer 300 formed on the first surface 300a; and a light emitting diode module 400 comprising a substrate 410 and at least one light emitting diode chip 450 disposed on the substrate 410. The substrate 410 of the light emitting diode module 400 is disposed on the conductive wiring layer 300 by a surface mount method. In one embodiment, the base is formed by the material selected from the group consisting of the following: aluminum with surface oxidization treatment, aluminum having an oxide layer on the surface, aluminum oxide, and aluminum nitride. The base is preferably of ceramics, for example, aluminum oxide. Even when 4000V or higher is applied on the base, the leakage current of the light emitting device remains very low. The leakage current is lower than the measurable scale, for example, lower than 1nA.

The above surface mount method means that the conventional surface mount technology is used to mount the LED module on the conductive wiring layer. For example, at first the metal wiring circuit is formed on the base and silver paste is screen printed or printed by an automatic dispenser on the first surface of the base. Firing is then carried out. The automatic dispenser is for example a liquid dispenser or resin dispenser mounted on a three-axis movable stage that is controlled by a computer and can move automatically in three dimensions according to the setting. A stainless steel stencil is used while coating soldering tin on the base. After reflow soldering, soldering flux is removed and then tin is bonded (connected) with the substrate of the LED module. Thus, no connecting or fixture member such as screws is needed to connect the base and the LED module. Besides, the above manufacturing processes can utilize a positioning point or a positioning tool (specific tool) to assist in automation.

The method for forming the conductive wiring layer 300 on the first surface comprises printing metal paste on the first surface by a screening printing method or using an automatic dispenser mounted on a three-axis movable stage and performing firing to thereby form the conductive wiring layer.

In one embodiment, the effective thermal conductivity of the solder paste, the interface between the solder paste and the substrate and the interface between the solder paste and the conductive wiring layer is equal to or more than 50 W/m-K. The "effective thermal conductivity (k_{eff}) " is defined as 1/k_{eff} =1/k₁+1/k₂+1/k₃ where k₂ denotes the thermal conductivity of the solder paste, k₁ denotes the thermal conductivity (k₁) of the interface (void) between the solder paste and the substrate, and k₃ denotes the thermal conductivity of the interface (void) between the solder paste and the conductive wiring layer. The above conductive wiring layer can be formed by silver paste and has a wiring pattern. In one embodiment, soldering tin is disposed between the conductive wiring layer and the substrate of the light emitting diode module.

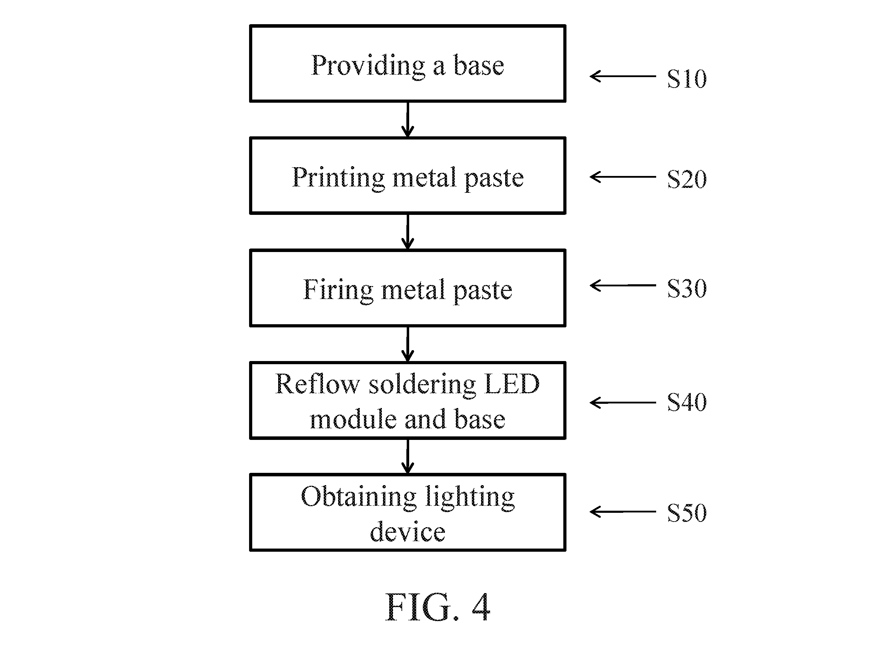

According to another embodiment of the invention, a method for forming a lighting device is disclosed and the flow chart is shown in FIG. 4. The method comprises: providing a base, having a first surface; forming a conductive wiring layer on the first surface; providing a light emitting diode (LED) module wherein the LED module comprises a substrate and a light emitting diode chip disposed on the substrate; and having the substrate of the LED module disposed on the conductive wiring layer by a surface mount method to thereby form the lighting device. In one embodiment, the base is formed by the material selected from the group consisting of the following: aluminum with surface oxidization treatment, aluminum having an oxide layer on the surface, aluminum oxide, and aluminum nitride. The base is preferably made of ceramic material. The ceramic material can be for example aluminum oxide or aluminum nitride and preferably aluminum oxide.

Since the base of the lighting device usually has a three-dimensional shape, that is, not of a flat plate or a thin film, the common screen printing equipment is used to process a flat object or a plate and thus according to the invention a specific tool is needed during screen printing. The screen printing equipment needs to be modified to adopt the non-planar type base of the lighting device of the invention. In another embodiment, an automatic dispenser can be used to print the required pattern. The automatic dispenser is a liquid dispenser or resin dispenser mounted on a three-axis moveable stage. For example, the three-axis moveable stage means a stage can move along x, y, and z axes.

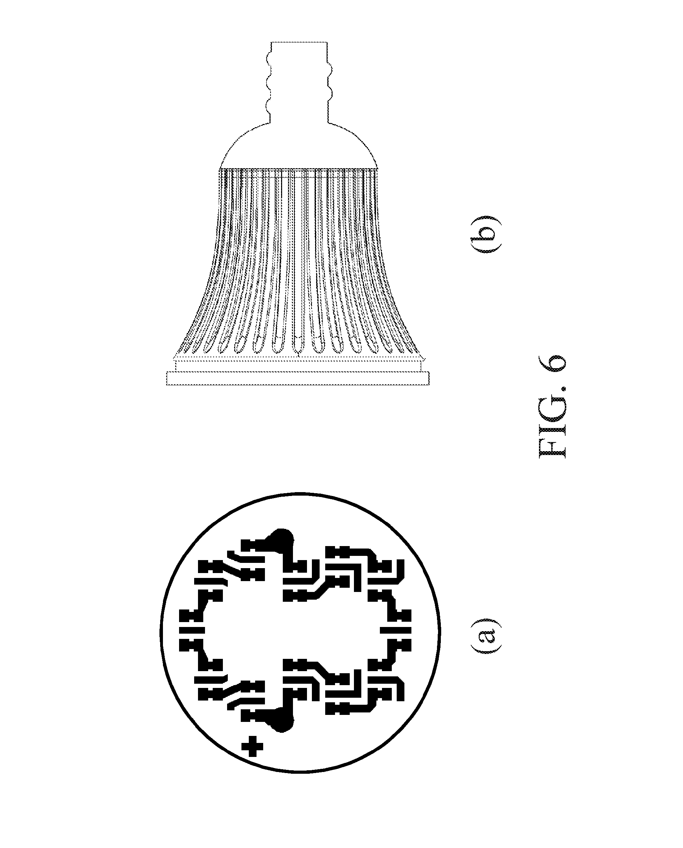

In one embodiment, the step of forming a conductive wiring layer on the first surface comprises printing metal paste on the first surface by a screening printing method or using an automatic dispenser and performing firing to thereby form the conductive wiring layer. The metal paste can be, for example, W, Mo-Mn, Cu, or Ag paste and preferably silver paste. The surface mount method uses solder paste to bond the substrate and the conductive wiring layer by reflow soldering. The conductive wiring layer can have a wiring pattern and the solder paste is preferably soldering tin. The wiring pattern is for example shown in FIG. 6(a).

The above method for forming a lighting device, for example, is shown in FIG. 4 where the step S10 is to provide a ceramic base; the step S20 is to print metal paste such as silver paste on the first surface by a screen printing method or an automatic dispenser to form a pattern shown in FIG. 6(a); the step S30 is to fire (or sinter) the metal paste to form the conductive wiring layer; the step S40 is to use solder such as soldering tin to bond the substrate of the LED module and the base by reflow soldering; and finally the step S50 is to obtain the lighting device of the invention.

In another embodiment, the step of forming a conductive wiring layer 300 on the first surface comprises: forming a first metal layer; forming a second metal layer; forming a film with a pattern on the second metal layer; simultaneously etching the first metal layer and the second metal layer to pattern the first metal layer and the second metal layer; and removing residue of the film. The above method can use a sputtering method to form the first metal layer and the sputtering target can be Ti or TiW. An electroplating method can be used to form the second metal layer and for example the second metal layer is a copper layer. In one embodiment, the method of forming a film with a pattern on the second metal layer is to use a printing method to form a film or a dry film with a pattern. In another embodiment, a photolithographic method can be used to form a film with a pattern where a photo resist is coated and then light exposure, developing and etching are performed to thereby form the film having the pattern.

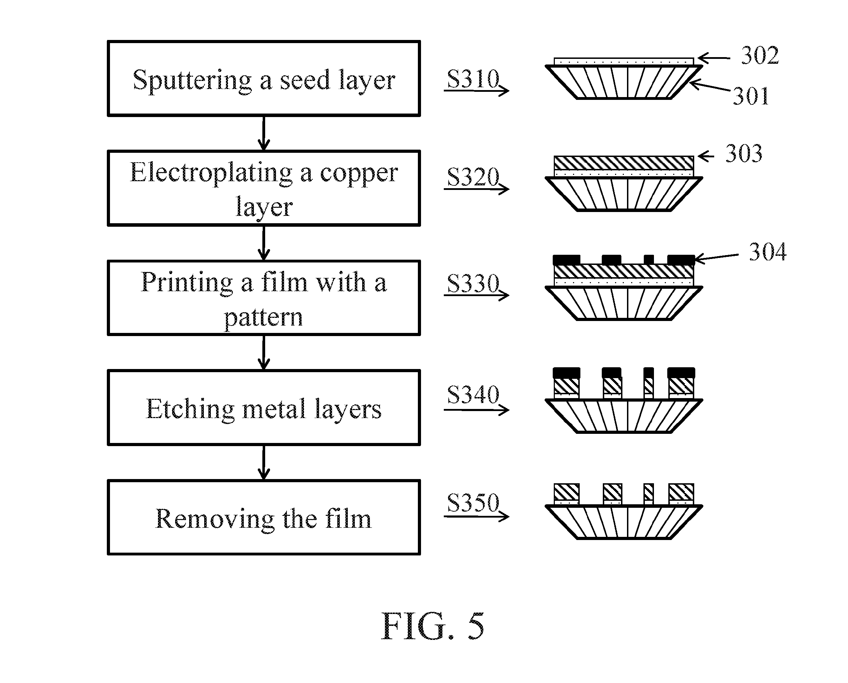

For example, FIG. 5 shows a flow chart illustrating the method for forming the conductive wiring layer 300 where on the right-hand side of FIG. 5 shows the cross-sectional schematic diagrams of the lighting device according to one embodiment of the invention. It should be noted that FIG. 5 is to show the structure of each layer and the size and the thickness are not scaled accordingly. In FIG. 5, 301 represents a base, 302 represents a seed layer (the first metal layer), 303 represents a copper layer (the second metal layer), and 304 represents a film. The step S310 is to sputter a first metal layer as the seed layer and the seed layer can be made of Ti or TiW. The step S320 is to electroplate a copper layer to form a second metal layer. The step S330 is to form a film with a pattern on the second metal layer. The step S340 is to pattern the first metal layer and the second metal layer by etching. Finally, the step S350 is to remove residue of the film. The conductive wiring layer 300 is thus formed.

Since the base of the lighting device usually has a three-dimensional shape, that is, not of a flat plate or a thin film, the common lithographic equipment is used to process a flat object or a plate and thus a spin coater cannot be used to process the base of the invention to perform coating a photo resist and developing and a common exposure equipment is not applicable to expose the photo resist on the base. Thus, according to the invention, a printing method is used to print a film with a pattern on the surface of the base and then the base is dipped in an etching solution or bath to thereby form the pattern of the conductive wiring layer on the surface of the base.

In one embodiment, the base of the lighting device is formed by a ceramic material and the effective thermal conductivity of the solder paste, the interface between the solder paste and the substrate and the interface between the solder paste and the conductive wiring layer is equal to or more than 50 W/m-K. The "effective thermal conductivity (k_{eff})" is defined as 1/k_{eff} =1/k₁+1/k₂+1/k₃ where k₂ denotes the thermal conductivity of the solder paste, k₁ denotes the thermal conductivity (k₁) of the interface (void) between the solder paste and the substrate, and k₃ denotes the thermal conductivity of the interface (void) between the solder paste and the conductive wiring layer.

In one embodiment, the screen printing method utilizes a specific tool to couple with the base to assist in coating the metal paste on the first surface.

When 4000V or higher is applied on the base, the leakage current of the light emitting device is is very low (lower than the measurable scale, such as less than 1 nA).

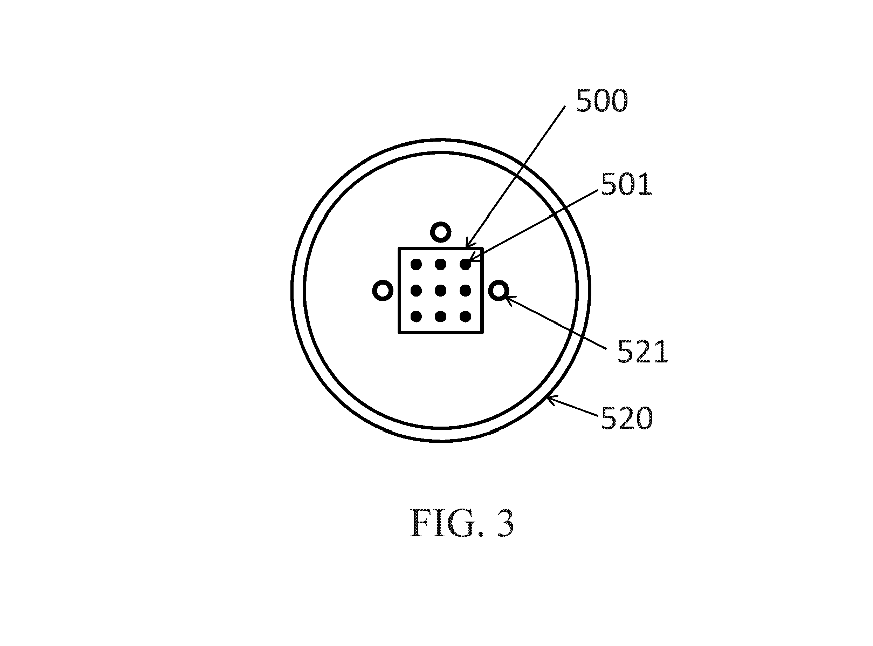

FIG. 3 shows a top-view schematic diagram illustrating the structure of the lighting device for simulating heat dissipation effect according to one embodiment of the invention where 500 represents the substrate (assuming A1 substrate) of the LED module, 501 represents a LED chip (1mm Width×1mm Lengthx2mm Thickness), and 520 represents the base, 521 represents a through hole on the base. In simulation, the heat flux of the LED chip is assumed to be 1W/mm2 and a total of 9W heat is to be dissipated. The heat flux of interfaces between components is continuous. The heat conductivity of the Al substrate is assumed to be 160 W/m-K. The base 520 is either a ceramic base or an aluminum base. It is assumed that the surface area of the ceramic base (Al₂O₃) is 2.037×10⁻²m² and the volume is 3.605×10⁻⁵m³, and the heat conductivity is 24 W/m-K. It is assumed that the surface area of the aluminum base (Al) is 2.037×10⁻²m² and the volume is 3.605×10⁻⁵m³, and the heat conductivity is 160 W/m-K. The radiation rate of the enamel paint sprayed on the surface of the aluminum base is assumed to be 0.5∼0.7. Besides, the heat conductivity of the heat dissipating plate is assumed to be 5 W/m-K and the heat conductivity of the soldering tin is assumed to be 60 W/m-K. It should be noted that the through hole 521 on the base shown in FIG. 3 is not an essential element for the present invention. That is, the base of the lighting device according to the present invention does not need to comprise any through hole 521.

From the simulation result for heat dissipation effect, (1) when the heat dissipating plate is used between the A1 substrate and the ceramic base, the junction temperature of the LED is 93.3°C; and (2) when the soldering tin is used between the Al substrate and the ceramic base, the junction temperature of the LED is 88.8°C. The result shows that using soldering tin according to the invention has a better heat dissipation effect than that using the heat dissipating plate. In addition, since the above simulation does not encounter the condition of voids existed at the interfaces between the heat dissipating plate and the base nor between the heat dissipating plate and the Al substrate, the actual difference of the heat dissipating effect between the soldering tin and the heat dissipating plate should be greater than the simulation result. In another simulation for a 16W light bulb, according to the invention, the junction temperature of LED chips is only around 81°C to be comparable to that of a 8W light bulb with the conventional structure. In other words, a 16W light bulb according to the invention has nearly the same junction temperature as an 8W light bulb with the conventional structure.

Furthermore, the heat dissipating effect for different radiation rates is compared. The aluminum base is used in simulation and it is found that one base with a higher radiation rate has the better heat dissipating effect. Therefore, the heat conductivity of metal aluminum is high but the radiation rate is low. The heat dissipating effect of the aluminum base is worse than that of the ceramic base.

According to the lighting of the invention, the base can be made of ceramic material and the shape is for example shown in FIG. 6(b). FIG. 6(a) shows the conductive wiring layer formed on the base. The bottom part of the base can comprise a screw-cap fitting, such as E26 or E27 standard screw-cap fitting. Therefore, the surface of the tail of the base has an electrical connector to electrically connect the LED module to the base, such as a household lamp holder.

In conclusion, according to the design of the lighting device and the method for forming the lighting device of the invention, manufacturing a lighting device can be done by automation and the production cost is decreased. Furthermore, the heat conductivity between the LED module and the base is increased to thereby increase the heat dissipation efficiency of the whole lighting device and lower the junction temperature of the LED during operation. Thus, the lifetime of the LED and brightness can be increased. Besides, when a ceramic base is used, the lighting device has high voltage durability. That is, the lighting device will not fail or is still operable even when 4000V or more than 4000V is applied on the base.

Although the present invention has been fully described by the above embodiments, the embodiments should not constitute the limitation of the scope of the invention. Various modifications or changes can be made by those who are skilled in the art without deviating from the spirit of the invention. Any embodiment or claim of the present invention does not need to reach all the disclosed objects, advantages, and uniqueness of the invention. Besides, the abstract and the title are only used for assisting the search of the patent documentation and should not be construed as any limitation on the implementation range of the invention.

## Claims

1. A method for forming a lighting device, comprising:
providing a base, having a first surface;
forming a conductive wiring layer on the first surface;
providing a light emitting diode (LED) module wherein the LED module comprises a substrate and a light emitting diode chip disposed on the substrate; and
having the substrate of the LED module disposed on the conductive wiring layer by a surface mount method to thereby form the lighting device.

2. The method according to claim 1, wherein the base is formed by the material selected from the group consisting of the following: aluminum with surface oxidization treatment, aluminum having an oxide layer on the surface, aluminum oxide, and aluminum nitride.

3. The method according to claim 1, wherein the step of forming a conductive wiring layer on the first surface comprises printing metal paste on the first surface by a screening printing method or using an automatic dispenser and performing firing to thereby form the conductive wiring layer.

4. The method according to claim 1, wherein the step of forming a conductive wiring layer on the first surface comprises:
forming a first metal layer;
forming a second metal layer;
forming a film with a pattern on the second metal layer;
simultaneously etching the first metal layer and the second metal layer to pattern the first metal layer and the second metal layer; and
removing residue of the film.

5. The method according to claim 1, wherein the surface mount method uses solder paste to bond the substrate and the conductive wiring layer together by reflow soldering.

6. The method according to claim 3, wherein the conductive wiring layer comprises a wiring pattern.

7. The method according to claim 3, wherein the metal paste is silver paste.

8. The method according to claim 5, wherein the metal paste is silver paste and the solder paste is soldering tin.

9. The method according to claim 1, wherein the effective thermal conductivity of the solder paste, the interface between the solder paste and the substrate and the interface between the solder paste and the conductive wiring layer is equal to or more than 50 W/m-K.

10. The method according to claim 3, wherein the screen printing method utilizes a specific tool to couple with the base to assist in coating the metal paste on the first surface.

11. The method according to claim 2, wherein, even when 4000V or more than 4000V is applied on the base, the leakage current of the light emitting device is less than 1 nA.

12. The method according to claim 4, wherein a sputtering method using a Ti or TiW sputtering target is used to form the first metal layer, an electroplating method is used to form the second metal layer, and the second metal layer is a copper layer.

13. A lighting device, comprising:
a base having a first surface;
a conductive wiring layer formed on the first surface; and
a light emitting diode module comprising a substrate and at least one light emitting diode chip disposed on the substrate wherein the substrate of the light emitting diode module is disposed on the conductive wiring layer by a surface mount method.

14. The device according to claim 13, wherein the base is formed by the material selected from the group consisting of the following: aluminum with surface oxidization treatment, aluminum having an oxide layer on the surface, aluminum oxide, and aluminum nitride.

15. The device according to claim 13, wherein the effective thermal conductivity of the solder paste, the interface between the solder paste and the substrate and the interface between the solder paste and the conductive wiring layer is equal to or more than 50 W/m-K.

16. The device according to claim 15, wherein the conductive wiring layer is formed by silver paste and comprises a wiring pattern.

17. The device according to claim 13, wherein soldering tin is disposed between the conductive wiring layer and the substrate of the light emitting diode module.

18. The device according to claim 13, wherein the conductive wiring layer comprises a multi-layer structure formed by sequentially laminating a seed layer and a copper layer; and the conductive wiring layer comprises a wiring pattern.

19. The device according to claim 18, wherein the method of forming the conductive wiring layer comprises:
sputtering a first metal layer as the seed layer wherein the seed layer is formed by titanium (Ti) or titanium tungsten (TiW) materials;
electroplating a copper layer as the second metal layer;
forming a film with a pattern on the second metal layer;
simultaneously etching the first metal layer and the second metal layer to pattern the first metal layer and the second metal layer; and
removing residue of the film.

20. The device according to claim 13, wherein, when 4000V or more than 4000V is applied on the base, the leakage current of the light emitting device is less than 1nA.
